# EUROPÄISCHE PATENTSCHRIFT

(11) **EP 0 299 951 B1**
(45) Veröffentlichungstag und Bekanntmachung des Hinweises auf die Patenterteilung: **08.03.1995**
(21) Anmeldenummer: 88890185.7
(22) Anmeldetag: 12.07.1988
(51) Int. Cl.: G03F 1/00

(54) **Vorrichtung und Verfahren zur Inspektion einer Maske**
Process and apparatus for mask inspection
Procédé et appareil pour l'inspection des masques

(30) Priorität: 13.07.1987 AT 1766/87
(43) Veröffentlichungstag der Anmeldung: 18.01.1989
(73) Patentinhaber: IMS Ionen Mikrofabrikations Systeme Gesellschaft m.b.H., A-1020 Wien (AT); Österreichische Investitionskredit Aktiengesellschaft, 1013 Wien (AT)
(72) Erfinder: Wolff, Eduard, Prof. Dr., Ithaca, N.Y. 14853 (US); Hammel, Ernst, Dr., A-1190 Wien (AT); Traher, Christian, A-1150 Wien (AT)
(74) Vertreter: Matschnig, Franz, Dipl.-Ing.

(56) Entgegenhaltungen:
- EP-A- 0 075 949
- DE-A- 3 410 885
- US-A- 4 099 055
- PATENT ABSTRACTS OF JAPAN vol. 11, no. 399 (P-651)(2846) 26 Dezember 1987 ; & JP-A-62 161 044
- PATENT ABSTRACTS OF JAPAN vol. 9, no. 227 (P-388)(1950) 13 September 1985 ; & JP-A-60 83 941

## Beschreibung

Die vorliegende Erfindung bezieht sich auf eine Vorrichtung zur Inspektion einer Maske für Röntgen- oder Korpuskular-, insbesondere Ionenstrahllithographie, bei welcher in dem Strahlengang einer Projektionseinrichtung für einen Inspektionsstrahl, insbesondere für einen Elektronen- oder Ionenstrahl ein mit einer Durchbrechung versehener, vorzugsweise als Koordinatentisch ausgebildeter und/oder drehbarer Aufnahmetisch für die zu inspizierende Maske und hinter der Maske ein Detektor angeordnet ist, dessen Signale einem Bildspeicher zuführbar sind. Ebenso bezieht sich die Erfindung auf ein Verfahren zum Inspizieren von Masken für die Röntgen- oder Korpuskular-, insbesondere Ionenstrahllithographie, bei welchem ein durch eine Projektionseinrichtung erzeugter und auf die Maske gerichteter Inspektionsstrahl durch einen hinter der Maske angeordneten Detektor in ein Signal verwandelt wird, welches einem Bildspeicher zuführbar ist.

Eine Vorrichtung der oben genannten Art ist aus der DE-A-3 410 885 bekannt geworden. Bei dieser Vorrichtung ist die Projektionseinrichtung ein Schattenwurf-Belichtungsgerät, welches einen parallelen, auf die Maske gerichteten Inspektionsstrahl mit einem großen Durchmesser erzeugt. Hinter der Maske ist eine verschiebbare Lochblende mit einer Abmessung im Submikronbereich und ein dahinter angeordneter Szintillationsdetektor für die durch die Maske und die Lochblende durchgehende Primärstrahlung vorgesehen. Durch seitliches Kippen des Inspektionsstrahles wird ein Schattenbild eines Ausschnittes der Maske über die Lochblende geführt und mittels des Szintillationsdetektors sequentiell aufgenommen.

Bei dieser bekannten Vorrichtung wird jedoch nur ein sehr kleiner Teil der Strahlung detektiert, wodurch insbesondere bei niedrigen Strahlenergien oder -intensitäten Auflösungsprobleme entstehen. Das für die Bildgewinnung erforderliche Kippen des Strahls hat eine durch die Dicke der Maske hervorgerufene Abbildungsverzerrung zur Folge. Durch die Lochblende gelangt zusätzlich elastische Streustrahlung in den Detektor, welche aus anderen, nicht abzubildenden Bereichen der Maske kommt. Weiters ist die Lochblende eine zusätzliche systematische Fehlerquelle für die Abbildung und begrenzt die Auflösung des Systems, nämlich einerseits durch die aus Intensitätsgründen gegebene Mindestgröße der Blendenöffnung und andererseits durch die Ortsbestimmung der Blende. Überdies können mittels der bekannten Vorrichtung, falls an den untersuchten Masken reparable Fehler festgestellt werden, keine Reparaturen vorgenommen werden.

Daher ist es eine Aufgabe der Erfindung eine Vorrichtung zur Inspektion von Masken anzugeben, bei welcher die oben angeführten Nachteile vermieden werden. Insbesondere ist es eine Aufgabe der Erfindung, eine Vorrichtung zu schaffen, welche in einfacher Weise realisierbar ist, geringe Fehlerquellen bei einer hohen Auflösung aufweist und bei welcher die Möglichkeit einer Reparatur der Maske gegeben ist. Weiters ist es eine Aufgabe der Erfindung, ein entsprechendes Verfahren zur Maskeninspektion anzugeben.

Diese Aufgaben werden ausgehend von einer Vorrichtung der eingangs genannten Art dadurch gelöst, daß die Projektionseinrichtung Mittel zur Feinfokussierung des Inspektionsstrahls und Mittel zum Abrastern eines bestimmten Bildfeldes der Maske mittels des feinfokussierten Strahls aufweist, daß in dem Strahlengang hinter der Maske eine im Bereich des Bildfeldes durch die Primärstrahlung des Inspektionsstrahls bestrahlbare Emitterfläche zur Erzeugung und Rückstreuung von Sekundärstrahlung des Inspektionsstrahls vorgesehen ist und daß der Detektor ein in Abstand von der Emitterfläche angeordneter Sekundärstrahlungsdetektor zur Aufnahme der durch die Emitterfläche rückgestreuten Sekundärstrahlung ist.

Weiters werden diese Aufgaben ausgehend von einem Verfahren der eingangs genannten Art in vorteilhafter Weise dadurch gelöst, daß der Inspektionsstrahl feinfokussiert über ein bestimmtes Bildfeld gerastert wird, daß der Primärstrahl des Inspektionsstrahls durch eine im Strahlengang hinter der Maske angeordnete, rückstreuende Emitterfläche in Sekundärstrahlung umgewandelt wird und daß diese Sekundärstrahlung durch einen in Abstand von der Emitterfläche angeordneten Sekundärstrahldetektor aufgenommen wird.

Unter Anwendung dieser Maßnahmen können handelsübliche Geräte, z.B. ein Elektronenmikroskop oder ein Elektronenstrahlmaskenschreiber, durch einfache Adaption in ein Maskeninspektionsgerät umgewandelt werden.

Der Inspektionsstrahl (fokussierter Elektronen- oder Ionenstrahl), welcher über die Maske gerastert wird, ist in seiner Energie so eingestellt, daß er im Fall der Röntgenstrahlmaske den Maskenfolienbereich durchdringen kann, jedoch in den Absorberschichten (z.B. aus etwa 1 »m dickem Gold oder Wolfram) eine bedeutende Abschwächung erfährt bzw. so abgebremst wird, daß in diesen Gebieten der Maskenfolie keine Durchdringung möglich ist. Im Fall der Inspektion von Maskenfolien für die Elektronen- oder Ionenstrahllithographie handelt es sich um die Inspektion dünner Folien mit Strukturöffnungen. Die Energie des Inspektionsstrahls wird in diesem Fall so eingestellt, daß der Inspektionsstrahl die Maskenfolie nicht durchdringen kann, jedoch ungehindert durch die Öffnungen der Maskenfolie gelangt. In beiden Fällen enthält der die Maske durchdringende Inspektionsstrahl eine exakte Ortsinformation und auch eine Information über den abgescannten Maskenstrukturbereich.

Mittels der erfindungsgemäßen Vorrichtung wird über die Sekundärquanten bzw. über die Sekundärstrahlung ein Durchlichtbild der inspizierten Maske erhalten, auf welchem im Vergleich zu einem Auflichtbild die Maskenkonturen wesentlich klarer, insbes. was deren Umriß betriff, erkennbar sind, wobei das Durchlichtbild in einem Bildspeicher aufgezeichnet werden kann.

Ein wesentlicher Vorteil der Erfindung besteht darin, daß die Inspektion mit bereits bestehenden Geräten nach bloß geringfügigem Umbau durchgeführt werden kann. Bei Verwendung von Elektronen als Inspektionsstrahl ergab sich - wie bereits erwähnt - ein Elektronenmikroskop. Soll zusätzlich zur Feststellung von Defekten auch die Lagegenauigkeit der Maskenstrukturen geprüft werden, so kann die Inspektion in Elektronenschreibegeräten durchgeführt werden, also in Geräten, wie sie zum Schreiben von Maskenstrukturen Verwendung finden.

Die Wahl des Inspektionsstrahls und die Wahl der Energie des Inspektionsstrahls richtet sich - insbesondere bei der Inspektion von Maskenfolien mit Öffnungen - nach dem Verwendungszweck der Maskenfolie. Wird beispielsweise bei der Ionenprojektionslithographie eine Maskenfolie mit Öffnungen, von einem Ionenstrahl mit 5 keV Energie bestrahlt, so erweist es sich als zweckmäßig, für die Inspektion einen Elektronenstrahl zu verwenden, dessen Energie so eingestellt wird, daß die Reichweite der Elektronen des Inspektionsstrahls, der Reichweite der bei Verwendung der Maske zur Ionenprojektionslithographie verwendeten Ionen annähernd entspricht. Auf diese Weise werden jene Defekte detektiert, die auch bei der Stukturübertragungsmethode relevant sind.

Verwendet man im Falle der Ionenstrahllithographie zur Inspektion Ionen derselben Art und Energie wie zur Lithographie, so werden nur diejenigen Unregelmäßigkeiten abgebildet, die auch in der Lithographie von Bedeutung sind, da die anderen ebenso wie bei der Lithographie durchsetzt werden.

Eine bevorzugte Ausbildung der erfindungsgemäßen Vorrichtung kennzeichnet sich dadurch, daß die Emitterfläche als Belag mit einer hohen Massenzahl, insbesondere als Edelmetall-, z.B. Goldbelag, aus einem aus Silizium bestehenden Wafer ausgebildet ist. Der Silizium-Wafer ist auf einem mit dem Aufnahmetisch verbundenen Halter befestigt. Eine Edelmetallauflage als Emitterfläche zeichnet sich durch einen besonders hohen Sekundärelektronen-Emissionskoeffizienten aus.

Die Feststellung der Art des Fehlers kann dadurch erleichtert werden, daß in Weiterbildung der Erfindung, zusätzlich zur Durchlichtaufnahme auch eine Aufsichtaufnahme ausgeführt werden kann. Erreicht wird dies, wenn, wie auch in Rasterelektronenmikroskopen üblich, in Weiterbildung der Erfindung, auf der der Emitterfläche abgewandten Seite des Aufnahmetisches der Maske ein weiterer Detektor (Auflichtdetektor) für Sekundärquanten bzw. Sekundärstrahlen, die von der Maske ausgehen, angeordnet ist und daß dieser Detektor Signale an eine weitere Bildspeichereinrichtung gibt.

Anhand der feststellbaren Unterschiede, die zwischen dem Aufsicht- und dem Durchsichtbild bestehen, kann auf die Art des Fehlers geschlossen werden, also etwa darauf, ob eine Fehleranzeige lediglich dadurch erfolgt ist, daß ein Staubkorn sich auf der Maske abgelagert hat oder ob tatsächlich ein Vorsprung in der Lochwandung oder gar eine das Loch querende Brücke vorhanden ist.

Durch Variation der Energie des Korpuskularstrahles ist es ebenfalls möglich, die Art des Fehlers festzustellen. Dies erfolgt auf dem Umweg über die Bestimmung der Materialstärke. Ein hochenergetischer Strahl ist nämlich imstande, eine größere Materialstärke zu durchsetzen als ein niederenergetischer Strahl. So wird z.B. ein Staubkorn von einem Strahl relativ niedriger Energie durchsetzt werden und im Durchlicht nicht mehr aufscheinen. Ein Strahl der gleichen Energie wird jedoch eine Materialbrücke nicht durchsetzen, wodurch in der Abbildung der Maskenöffnung festgestellt werden kann, daß an der betreffenden Stelle eine Materialbrücke vorhanden ist.

Kleinere Fehler der Maske können in der Vorrichtung selbst repariert werden. Zu diesem Zweck wird in weiterbildung der Erfindung von einer Edelgaskanone, insbesondere Argonkanone, Gebrauch gemacht, die auf der der Emitterfläche abgewandten Seite des Aufnahmetisches angeordnet ist und die gegen die Durchbrechung des Aufnahmetisches gerichtet ist.

Eine weitere Möglichkeit, die Art des Fehlers zu ermitteln, besteht im zusätzlichen Einsatz eines Röntgenstrahldetektors, der in einer bevorzugten Ausführungsform des Erfindungsgegenstandes des im Bereich zwischen dem Auflagetisch für die Maske und der Emitterfläche angeordnet und gegen die Durchbrechung des Auflagetisches gerichtet ist. Ein derartiger Röntgenstrahldetektor ermöglicht Rückschlüsse vor allem auf die chemische Zusammensetzung des georteten Fehlers.

Mittels der erfindungsgemäßen Vorrichtung können auch Verunreinigungen durch dünne Schichten, welche Aufladungserscheinungen auf Masken verursachen, und die dann zu einer lokalen Verzerrung des Bildes der Maske auf dem Chip führen würden, erkannt werden. Solche Fehler könnten von Systemen, die von Photonen Gebrauch machen, nicht erkannt werden, da Photonen nicht zwischen leitenden und nichtleitenden Materialien unterscheiden können. Darüberhinaus erlauben Korpuskularstrahlen die Untersuchung auch feinster Strukturen, welche bei Verwendung von Photonen wegen der auftretenden Beugungserscheinungen nicht mehr beobachtet werden können. Dadurch ist es möglich, Abweichungen im Submikrometerbereich festzustellen.

Die Ortsinformation wird mittels eines Koordinatentisches (x-y Tisch) mit Laserinterferometer erhalten. Ein Referenzpunkt definiert dabei den Ausgangspunkt für die Messung (Ausgangspunkt des Koordinatensystems). Als Referenzpunkt kann hiebei etwa eine Alignmentmarke dienen.

Zunächst wird durch Grobtischverschiebung die Referenzmarke der Maske in das Bildfeld der Inspektionseinrichtung gebracht, und die gemessenen Koordinaten werden als Nullpunkt definiert. Die Größe des Bildfeldes ist durch die Scanbreite +-Δx und +-Δy gegeben, sodaß in ein und derselben Tischposition die Fläche 2Δx . 2Δy durch den Strahl abgescannt wird, wobei über den Detektor, die Abspeicherung im Bildspeicher erfolgt. Das Ergebnis stellt nun ein Bild der Maskenstruktur (z.B. einen Steg oder ein Gitter) dar.

Durch einen Vergleich des im Bildspeicher bereits eingespeicherten Sollbildes mit dem durch Scannung erhaltenen Istbild im Speicher werden die Koordinaten der Fehler im Feld der Größe 4Δx . Δy erhalten.

Um die gesamte Maske zu untersuchen, wird das Maskenfeld mit Teilfeldern der Größe 4Δx . Δy überzogen. Die jeweiligen tatsächlichen Koordinaten des Fehlers ergeben sich als vektorielle Summe aus den Koordinaten des Tisches und den Bildspeicherkoordinaten des Korpuskularstrahlensystems. Die tatsächlichen Koordinaten der Fehlerstellen werden auf einem Datenträger, z.B. Band, abgespeichert und können dann zum Auffinden der Fehlerstelle in einer Reparatureinrichtung verwendet werden.

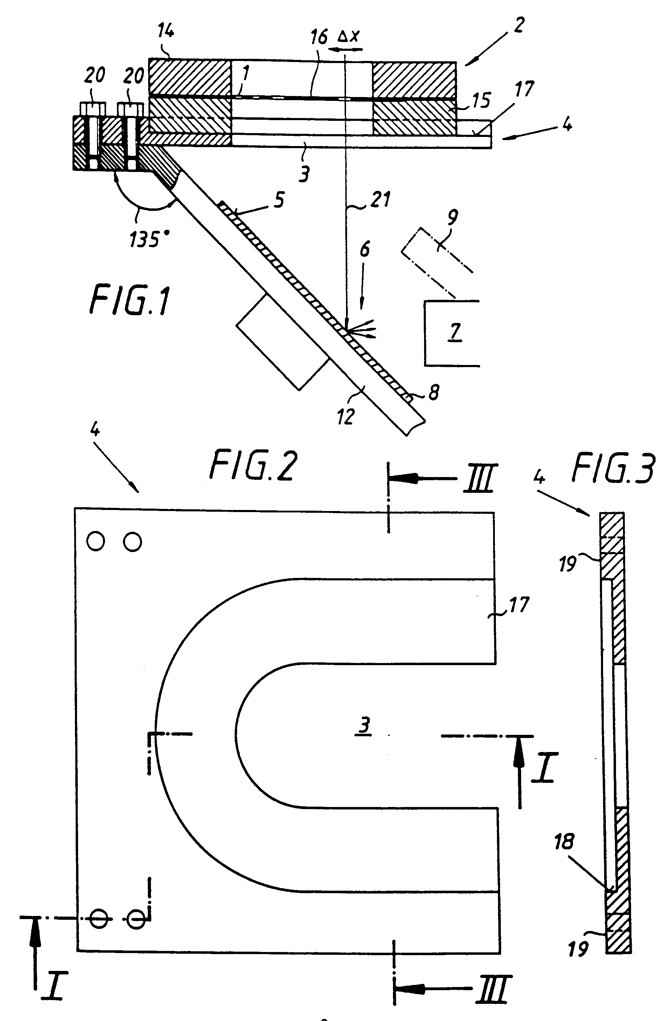

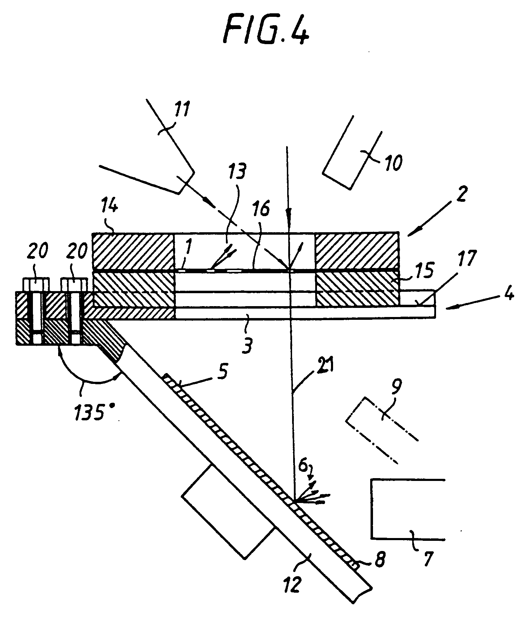

Die Erfindung wird nachstehend anhand der Zeichnung beispielsweise näher erläutert. Es zeigt, Fig. 1 einen Schnitt durch eine erfindungsgemäße Vorrichtung nach der Linie I-I in Fig. 2, die eine Draufsicht auf die erfindungsgemäße Vorrichtung bei aus der Vorrichtung entfernter Maske zeigt, Fig. 3 einen Schnitt entlang der Linie III-III in Fig. 2, und Fig. 4 eine gegenüber Fig. 1 modifizierte Ausführungsform einer erfindungsgemäßen Vorrichtung.

In der Zeichnung ist mit 2 eine Maske bezeichnet, die im dargestellten Ausführungsbeispiel aus zwei Halteringen 14, 15 besteht, zwischen welchen die eigentliche Maskenfolie 16 eingespannt ist. Die Maskenfolie besitzt Strukturen, die von Durchbrechungen 1 gebildet werden und unterschiedliche Gestalt auf der Folie 16 aufweisen. Im Strahlengang eines Elektronenmikroskops ist ein Aufnahmetisch 4 für die zu inspizierende Maske 2 angeordnet. Dieser Aufnahmetisch 4 besitzt eine Durchbrechung 3 für den Durchgang der Ionenstrahlen, nachdem diese die Öffnungen 1 der Maske durchsetzt haben. Die Maske 2 ist auf eine U-förmig gestaltete Auflagefläche 17 des Tisches 4 mit ihrem unteren Haltering 15 auflegbar. Die Auflagefläche 17 ist über eine Schulter 18 von der Oberfläche 19 des Tisches 4 abgesetzt. Unter der Durchbrechung 3 des Aufnahmetisches 4 ist eine Emitterfläche 5 für Sekundärstrahlung 6 angeordnet. Diese Sekundärstrahlung wird durch Strahlen 21 erzielt, welche die Durchbrechungen 1 der Maskenfolie 16 durchsetzt haben und auf die Emitterfläche 5 auftreffen. Im Einfangsbereich der Sekundärstrahlung 6 ist ein Detektor 7 für diese Sekundärstrahlung angeordnet. Dieser Detektor 7 liefert der Sekundärstrahlung entsprechende Signale, die einem Bildspeicher zur Abspeicherung zugeführt werden.

Die vom Detektor 7 erzeugten Signale können vor dem Bildspeicher noch modifiziert werden. Die Emitterfläche 5 ist auf einem Halter 12 angeordnet, der mit dem Aufnahmetisch 4 für die Maske 2 verbunden ist, beispielsweise mittels Schrauben 20. auf dem Halter 12 ist ein bevorzugt aus Silizium bestehender Wafer 8 befestigt, auf dem ein Goldbelag als Coat zur Bildung der Emitterfläche aufgebracht ist. Die Emitterfläche 5 ist als plane Fläche ausgebildet.

Wie Fig. 4 erkennen läßt, kann auf der der Emitterfläche 5 abgewandten Seite des Aufnahmetisches 4 der Maske 2 ein weiterer Detektor 10 für Sekundärstrahlung 13 angeordnet sein, die von der Maske 12 ausgeht. Dieser Detektor 10 arbeitet also im Auflichtverfahren, er gibt seine Signale an eine weitere Bildspeichereinrichtung ab.

Um Fehler der Maske unmittelbar nach ihrer Erkennung reparieren zu können, ist an der der Emitterfläche 5 abgewandten Seite des Aufnahmetisches 4 eine Edelgaskanone 11 angeordnet, die gegen die Durchbrechung 3 des Aufnahmetisches 4 gerichtet ist. Diese liefert einen auf der Maske fokussierten Ionenstrahl, welcher einen als Materialanhäufung ausgebildeten Defekt nach und nach wegsputtert. Durch Verschieben des Tisches können jeweils die zu bearbeitenden Defekte in den Wirkungsbereich des Edelgasionen-Strahls gebracht werden.

Eine erhöhte Lagenauigkeit der Maskenreparatur kann durch eine Ionenstrahlanordnung erreicht werden, in der der Inspektionsstrahl nach erfolgter Inspizierung und erfolgter Fehlerfeststellung durch einen Reparaturstrahl ersetzt wird, indem beispielsweise eine Duoplasmatronquelle verwendet wird, die leichte (z.B. Wasserstoff) und schwere (z.B. Argon) Ionensorten liefern kann. Über eine Massenfilteranordnung kann jeweils die gewünschte Ionensorte durch die ionenoptische Anordnung auf das Substrat (Maske) gerichtet werden. Nach der Inspektion und der Erkennung eines Defektes mit Hilfe eines Wasserstoff (oder Helium-) Ioneninspektionsstrahls kann die Reparatur nach Änderung der Ionensorte, beispielsweise auf Argonionen, durchgeführt werden, wobei über die Sputterwirkung überschüssige Maskendefektbereiche entfernt werden können. Die Reparatur von Pinhole-Defekten kann durch ionenstrahlinduzierte Abscheidungen bewirkt werden, wobei hier auch eine Nachbearbeitung der durch Abscheidung unerwünscht bedeckten Bereiche, durch nachfolgenden definierten Sputterabtrag möglich ist. Das Prinzip einer derartigen ionenoptischen Anordnung (FIRE: Fokussierte Ionenreparatureinrichtung) ist in der Zeitschrift Solid State Technology, Vol.29, Heft 2, Seite 119 - 126, Febr. 1986 beschrieben.

Zur Erkennung der Art eines etwaigen Fehlers der Maske kann in einer Ausführungsform der Erfindung im Bereich zwischen dem Auflagetisch 4 für die Maske 2 und der Emitterfläche 5 ein Röntgenstrahldetektor 9 (EDS Detektor) angeordnet sein, der gegen die Durchbrechung des Auflagetisches 4 gerichtet ist.

## Patentansprüche

1. Vorrichtung zur Inspektion einer Maske (2) für Röntgen- oder Korpuskular-, insbesondere Ionenstrahllithographie, bei welcher in dem Strahlengang einer Projektionseinrichtung für einen Inspektionsstrahl (21), insbesondere für einen Elektronen- oder Ionenstrahl, ein mit einer Durchbrechung versehener, vorzugsweise als Koordinatentisch ausgebildeter und/oder drehbarer Aufnahmetisch (4) für die zu inspizierende Maske (2) und hinter der Maske (2) ein Detektor (7) angeordnet ist, dessen Signale einem Bildspeicher zuführbar sind, **dadurch** **gekennzeichnet, daß** die Projektionseinrichtung Mittel zur Feinfokussierung des Inspektionsstrahls und Mittel zum Abrastern eines bestimmten Bildfeldes der Maske (2) mittels des feinfokussierten Strahls aufweist, **daß** in dem Strahlengang hinter der Maske (2) eine im Bereich des Bildfeldes durch die Primärstrahlung des Inspektionsstrahls (21) bestrahlbare Emitterfläche (5) zur Erzeugung und Rückstreuung von Sekundärstrahlung (6) des Inspektionsstrahls (21) vorgesehen ist **und daß** der Detektor (7) ein in Abstand von der Emitterfläche (5) angeordneter Sekundärstrahlungsdetektor zur Aufnahme der durch die Emitterfläche (5) rückgestreuten Sekundärstrahlung (6) ist.

2. Vorrichtung nach Anspruch 1, **dadurch gekennzeichnet, daß** die Emitterfläche (5) auf einem mit dem Aufnahmetisch (4) für die Maske (2) verbundenen Halter (12) als ein ebener, bezüglich der Primärstrahlung des Inspektionsstrahles geneigt angeordneter Belag mit einem hohen Sekundärelektronen-Emissionskoeffizienten, vorzugsweise aus einem Edelmetall, wie z.B. Gold, ausgebildet ist.

3. Vorrichtung nach Anspruch 1 oder 2, **dadurch gekennzeichnet, daß** in Primärstrahlrichtung vor der Maske (2) ein weiterer Sekundärstrahlungsdetektor (10) für die von der Maske (2) rückgestreuten Sekundärstrahlen (13) angeordnet ist.

4. Vorrichtung nach einem der Ansprüche 1 bis 3, **dadurch gekennzeichnet, daß** in Primärstrahlrichtung vor der Maske (2) eine auf die Maske gerichtete Edelgaskanone (11), insbesondere eine Argonkanone, angeordnet ist.

5. Vorrichtung nach einem der Ansprüche 1 bis 4, **dadurch gekennzeichnet, daß** im Bereich zwischen der Maske (2) und der Emitterfläche (5) ein gegen die Maske (2) gerichteter Röntgenstrahldetektor (z.B. EDS-Detektor) angeordnet ist.

6. Verfahren zum Inspizieren von Masken (2) für die Röntgen- oder Korpuskular-, insbesondere Ionenstrahllithographie, bei welchem ein durch eine Projektionseinrichtung erzeugter und auf die Maske (2) gerichteter Inspektionsstrahl (21) durch einen hinter der Maske (2) angeordneten Detektor (7) in ein Signal verwandelt wird, welches einem Bildspeicher zuführbar ist, **dadurch gekennzeichnet, daß** der Inspektionsstrahl (21) feinfokussiert über ein bestimmtes Bildfeld gerastert wird, **daß** der Primärstrahl des Inspektionsstrahls (21) durch eine im Strahlengang hinter der Maske angeordnete Emitterfläche (5) in rückgestreute Sekundärstrahlung (6) umgewandelt wird **und daß** diese Sekundärstrahlung (6) durch einen in Abstand von der Emitterfläche (5) angeordneten Sekundärstrahldetektor (7) aufgenommen wird.

7. Verfahren nach Anspruch 6 zur Inspektion von Masken für Ionenprojektionslithographie mittels eines fokussierten Elektronenstrahls, **dadurch gekennzeichnet, daß** die Elektronen des Inspektionsstrahls so stark beschleunigt werden, daß ihre Reichweite annähernd gleich der Reichweite der Ionen ist, welchen die Maske (2) bei der Ionenstrahllithographie ausgesetzt ist.

8. Verfahren nach Anspruch 6 oder 7, **dadurch gekennzeichnet, daß** zur Inspektion der Maske Ionen einer leichten Ionensorte, z.B. Wasserstoff, und zur Reparatur der Maske, d. i. Abtragen oder Anlagern von Material, Ionen einer schwereren Ionensorte, z.B. Argon, verwendet werden.

9. Verfahren nach Anspruch 8, **dadurch gekennzeichnet, daß** die leichten und die schwereren Ionen aus einer einzelnen Ionenquelle, z.B. einer Duoplasmatronquelle, emittiert und durch ein Massenfilter voneinander getrennt werden.

## Claims

1. A device for inspection of a mask (2) for X-ray or corpuscular lithography, in particular ion beam lithography, in which, in the beam path of a projection device for an inspection beam (21), in particular for an electron or ion beam, a receiving table (4) in disposed, which is provided with a through opening and preferably rotatably formed or formed as a coordinate table, for the mask (2) which is to be inspected, and behind the mask (2) a detector (7) is disposed, of which the signals can be fed to an image storage device, characterised in that the projection device comprises means for finely focussing the inspection beam and means of scanning a predetermined image field of the mask (2) by means of the finely focussed beam, that in the beam path behind the mask (2) an emitter surface (5) for the production and back scattering of secondary radiation (6) of the inspection beam (21) is provided which can be exposed to radiation in the region of the image field by the primary radiation of the inspection beam (21) and in that the detector (7) is a secondary radiation detector, disposed at a distance from the emitter surface, for receiving the secondary radiation (6) back scattered by the emitter surface (5).

2. A device according to claim 1, characterised in that the emitter surface (5) on a support (12), connected to the receiving table (4) for the mask (2), is formed as a level covering which is disposed inclined with respect to the primary radiation of the inspection beam and has a high secondary electron emission coefficient, preferably from a precious metal such as gold, for example.

3. A device according to claim 1 or 2, characterised in that in the primary beam direction in front of the mask (2) a further secondary radiation detector (10) is disposed for the secondary beams (13) back scattered by the mask (2).

4. A device according to any of claims 1 to 3, characterised in that in the primary beam direction in front of the mask (2) a noble gas canon (11) directed onto the mask is disposed, in particular an argon canon.

5. A device according to any of claims 1 to 4, characterised in that in the region between the mask (2) and the emitter surface (5) an X-ray beam detector (eg EDS detector) is disposed directed against the mask (2).

6. A process for inspecting masks (2) for X-ray or corpuscular lithography, in particular ion beam lithography, in which an inspection beam (21) produced by a projection device and directed onto the mask (2), is changed into a signal by a detector (7) disposed behind the mask (2), which signal can be fed to an image storage device, characterised in that the inspection beam (21) is scanned in a finely focussed manner over a predetermined image field, that the primary beam of the inspection beam (21) is changed by an emitter surface (5) disposed in the beam path behind the mask into back scattered secondary radiation (6) and that this secondary radiation (6) is detected by a secondary beam detector (7) disposed at a distance from the emitter surface (5).

7. A process according to claim 6, for the inspection of masks for ion projection lithography by means of a focussed electron beam, characterised in that the electrons of the inspection beam are accelerated so strongly that their coverage area is almost the same as the coverage area of the ions to which the mask (2) is exposed during ion beam lithography.

8. A process according to claim 6 or 7, characterised in that in order to inspect the mask, ions of a light ion type, for example hydrogen, are used and in order to repair the mask, ie removing and applying material, ions of a heavier ion type, for example argon, are used.

9. A process according to claim 8, characterised in that the light and the heavy ions are emitted from a single ion source, for example a duoplasmatron source, and are separated from each other by a spectrometer.

## Revendications

1. Dispositif pour inspecter un masque (2) pour la lithographie utilisant un faisceau de rayons X ou un faisceau corpusculaire, notamment la lithographie utilisant un faisceau d'ions, et dans lequel dans le trajet du rayonnement d'un dispositif de projection pour un rayon d'inspection (21), notamment pour un faisceau d'électrons ou un faisceau d'ions, sont disposés une table de support (4), qui est équipé d'un passage traversant, est réalisée de préférence sous la forme d'une table de coordonnées et/ou est rotative et sert à recevoir le masque (2) à inspecter, et, en arrière du masque (2), un détecteur (7), dont les signaux peuvent être envoyés à une mémoire d'images caractérisé en ce que le dispositif de projection comporte des moyens pour réaliser la focalisation précise du faisceau d'inspection et des moyens pour exécuter un balayage de trame d'une zone d'image déterminée du masque (2) à l'aide d'un faisceau finement focalisé, qu'une surface émettrice (5), qui peut être irradiée par le rayonnement primaire du faisceau d'inspection (21) au niveau de la zone d'image et sert à produire et à rétrodiffuser un rayonnement secondaire (6) du faisceau d'inspection (21), est prévue dans le trajet du rayonnement en arrière du masque (2) et que le détecteur (7) est un détecteur de rayonnement secondaire, qui est placé à distance de la surface émettrice (5) et sert à recevoir le rayonnement secondaire (6) rétrodiffusé par la surface émettrice (5).

2. Dispositif selon la revendication 1, caractérisé en ce que la surface émettrice (5) est réalisée, sur un support (12) relié à la table (4) de réception du masque (2), sous la forme d'un revêtement plan, qui est incliné par rapport au rayonnement primaire du faisceau d'inspection et a un coefficient élevé d'émission d'électrons secondaires, et est réalisée de préférence en un métal précieux, comme par exemple de l'or.

3. Dispositif selon la revendication 1 ou 2, caractérisé en ce qu'un autre détecteur de rayonnement secondaire (10) pour les rayons secondaires (13) rétrodiffusés par le masque (2) est disposé en avant du masque (2) dans la direction du faisceau primaire.

4. Dispositif selon l'une des revendications 1 à 3, caractérisé en ce qu'un canon à gaz rare (11), dirigé vers le masque, notamment à canon à argon, est disposé en avant du masque (2) dans la direction du rayonnement primaire.

5. Dispositif selon l'une des revendications 1 à 4, caractérisé en ce qu'un détecteur de faisceaux de rayons X (par exemple détecteur EDS), dirigé vers le masque (2), est disposé dans la zone située entre le masque (2) et la surface émettrice (5).

6. Procédé pour inspecter des masques (2) pour la lithographie utilisant un faisceau de rayons X ou un faisceau corpusculaire, notamment la lithographie utilisant un faisceau d'ions, et selon lequel un faisceau d'inspection (21), qui est produit par un dispositif de projection et est dirigé sur le masque (2), est converti, par un détecteur (7) disposé en arrière du masque (2), en un signal qui peut être envoyé à une mémoire d'images, caractérisé en ce qu'on déplace le faisceau d'inspection finement focalisé (21) selon un balayage de trame sur une zone d'image déterminée, que le rayonnement primaire du faisceau d'inspection (24) est converti, par une surface émettrice (25) disposée en arrière du masque dans le trajet du rayonnement, en un rayonnement secondaire rétrodiffusé (6), et que ce rayonnement secondaire (6) est reçu par un détecteur (7) du rayonnement secondaire, qui est disposé à distance de la surface émettrice (5).

7. Procédé selon la revendication 6 pour l'inspection de masques pour la lithographie à projection d'ions, à l'aide d'un faisceau focalisé d'électrons, caractérisé en ce que les électrons du faisceau d'inspection sont si fortement accélérés que leur portée est approximativement égale à la portée des ions, auquel le masque (2) est soumis dans le cas de la lithographie utilisant un faisceau d'ions.

8. Procédé selon la revendication 6 ou 7, caractérisé en ce que pour l'inspection des masques, on utilise des ions d'un type léger, par exemple l'hydrogène, et pour la réparation des masques, c'est-à-dire pour l'enlèvement ou l'accumulation d'un matériau, on utilise des ions d'un type plus lourd, par exemple l'argon.

9. Procédé selon la revendication 8, caractérisé en ce que les ions légers et les ions plus lourds sont émis par une source individuelle d'ions, par exemple une source duoplasmatron, et sont séparés les uns des autres par un filtre de masse.
